(19) Europäisches Patentamt
European Patent Office
Office européen des brevets

(11) **EP 2 741 310 B1**

(12) **FASCICULE DE BREVET EUROPEEN**

(45) Date de publication et mention
de la délivrance du brevet:
**14.06.2017 Bulletin 2017/24**

(51) Int Cl.:
*H01J 37/02* *(2006.01)*     *H01J 37/244* *(2006.01)*
*H01J 37/256* *(2006.01)*

(21) Numéro de dépôt: **14156672.9**

(22) Date de dépôt: **29.04.2011**

(54) **Système de détection de cathodoluminescence optimisant la collection du signal, la résolution spectrale et la conservation de la brillance, et microscope mettant en oeuvre un tel système**

Kathodolumineszenz-Detektionssystem mit optimierter Signalaufnahme, Spektralauflösung und Brillanzerhaltung, und Mikroskop, das dieses System verwendet

System for detecting cathodoluminescence optimising the collection of the signal, the spectral resolution and the preservation of brightness, and microscope implementing such a system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2010 FR 1054108**

(43) Date de publication de la demande:
**11.06.2014 Bulletin 2014/24**

(62) Numéro(s) de document de la (des) demande(s) initiale(s) en application de l'article 76 CBE:
**11723543.2 / 2 577 707**

(73) Titulaires:
• **Centre National de la Recherche Scientifique**
**75016 Paris (FR)**
• **Université Paris-Sud**
**91400 Orsay (FR)**

(72) Inventeurs:
• **Kociak, Mathieu**
**91120 Palaiseau (FR)**
• **Zagonel, Luiz Fernando**
**13084-791 Sao P Campinas (BR)**
• **Tence, Marcel**
**92130 Issy-les-Moulineaux (FR)**
• **Mazzucco, Stefano**
**Cambridge CB4 1GF (GB)**

(74) Mandataire: **Pontet Allano & Associes**
**Parc Les Algorithmes, Bâtiment Platon**
**CS 70003 Saint-Aubin**
**91192 Gif-sur-Yvette Cedex (FR)**

(56) Documents cités:
EP-A1- 1 956 632     EP-A2- 0 306 790
EP-A2- 1 739 715     EP-A2- 1 956 633
GB-A- 2 314 926      JP-A- 2003 157 789
US-A- 5 358 806      US-A1- 2002 074 939
US-A1- 2003 053 048  US-A1- 2003 057 377
US-A1- 2008 315 093  US-B1- 6 476 387

**Description**

La présente invention concerne un système de détection de cathodoluminescence. Elle concerne également un microscope mettant en oeuvre un tel système.

Le domaine de l'invention est le domaine de la cathodoluminescence et plus particulièrement le domaine des systèmes utilisant des particules chargées tels que des microscopes à particules chargées, par exemple les microscopes utilisant le principe de la cathodoluminescence.

On connaît actuellement de nombreux systèmes de détection de cathodoluminescence couplés à des microscopes à particules chargées, tels que des microscopes électroniques à transmission (MET) ou à balayage (METB).

L'effet physique utilisé dans ces microscopes, appelé cathodoluminescence, est basé sur la détection de signaux optiques émis du fait d'une excitation par un faisceau de particules chargées. Les microscopes utilisés sont dotés d'un canon de particules chargées produisant un faisceau de particules chargées qui est envoyé sur un échantillon étudié. L'échantillon frappé par ce faisceau de particules est excité et émet à son tour un rayonnement lumineux. Le rayonnement lumineux est collecté par une optique de collection dont le rôle est de diriger ce rayonnement lumineux vers des moyens d'analyse de ce rayonnement lumineux. Des moyens dits d'adaptation peuvent être disposés entre l'optique de collection et les moyens d'analyse pour modifier et transporter le rayonnement lumineux à l'entrée des moyens d'analyse. Un tel microscope est décrit dans le brevet US 7,589,322. L'optique de collection se trouve dans une chambre à vide du microscope.

On connait le document US-A-2003/053048 qui divulgue un système de détection de cathodoluminescence comprenant une optique de collection qui peut être déplacée par translation entre une position rétractée et fonctionnelle suivant l'axe optique. Ce système comprend en outre des moyens pour ajuster l'inclinaison de l'optique de collection

Cependant, les systèmes de détection de cathodoluminescence actuellement connus ne sont pas souples. Ces microscopes et les systèmes de détection de cathodoluminescence qu'ils mettent en oeuvre ne permettent pas une optimisation de la collection du rayonnement lumineux combinée à la conservation de l'intensité et de la brillance (intensité par unité d'aire et d'angle solide) le long du parcours lumineux et jusqu'aux moyens d'analyse. En particulier, ils ne permettent pas d'obtenir une collection optimale du signal lumineux combinée à une résolution spectrale optimale.

Un but de la présente invention est de remédier aux inconvénients précités.

Un autre but de la présente invention est de proposer un système de détection de cathodoluminescence permettant d'améliorer la collection du rayonnement lumineux.

En outre, un autre but de l'invention est de proposer un système de détection de cathodoluminescence permettant de conserver à la fois l'intensité et la brillance du signal collecté sur l'ensemble du parcours rayonnement lumineux.

Selon l'invention, au moins l'un de ces buts est atteint par un système de détection de cathodoluminescence selon la revendication 1.

Des modes de réalisation de l'invention sont décrits dans les revendications 2 à 15.

Dans la présente demande, les termes « amont » et « aval » sont définis par rapport et dans le sens du trajet du rayonnement lumineux, c'est-à-dire le sens allant de la source d'émission de particules chargées vers l'échantillon, puis vers l'optique de collection et enfin vers les moyens d'analyse du rayonnement lumineux.

L'optique de collection est définie comme étant l'ensemble des éléments réalisant la collecte du rayonnement lumineux émanant de l'échantillon et renvoyant ce rayonnement lumineux vers les moyens d'analyse.

Le système peut comprendre des moyens de positionnement sur au moins une dimension de l'optique de collection. Le système permet ainsi de conserver la résolution spectrale et l'intensité du rayonnement sur l'ensemble du parcours.

Premièrement, le système permet de positionner l'optique de collection par rapport à la source d'émission du faisceau de particules chargées sans en modifier le flux de particules chargées.

Deuxièmement, le système permet à chaque utilisateur d'optimiser le positionnement de l'optique collection de manière à obtenir le positionnement permettant de collecter un maximum de rayonnement lumineux émanant de l'échantillon étudié.

Enfin, en donnant la possibilité de repositionner l'optique de collection, le système permet à chaque utilisateur de positionner cette optique de collection de manière à s'assurer d'une part que l'intensité du rayonnement lumineux collecté par l'optique de collection soit conservée jusqu'aux moyens d'analyse et d'autre part que l'optique de collection ou l'optique suivant l'optique de collection permette de former une tâche de dimension ultimement limitée par les lois de l'optique géométrique et de la diffraction, à partir du rayonnement émis.

Avantageusement, les moyens de positionnement de l'optique collection peuvent comprendre des moyens de translation de ladite optique de collection sur au moins une dimension.

Les moyens de positionnement de l'optique collection peuvent en outre comprendre des moyens de rotation de ladite optique de collection autour d'au moins un axe de rotation.

Avantageusement, les moyens de positionnement peuvent comprendre au moins un élément de positionnement, par exemple une vis micrométrique, un actuateur piézoélectrique ou capacitif, chaque élément de positionnement étant prévu pour déplacer directement ou indirectement ladite optique de collection sur au moins une dimension.

Ainsi, les moyens de positionnement, respectivement les moyens de rotation, peuvent permettre à un utilisateur d'améliorer le positionnement de l'optique de collection sur les trois dimensions de l'espace, respectivement les trois angles d'Euler.

Dans un mode de réalisation particulier, l'optique de collection peut comprendre un miroir parabolique renvoyant le rayonnement lumineux, par exemple de manière collimatée. Dans ce cas, le miroir parabolique peut comprendre une ouverture traversante disposée en regard de la source d'émission de particules chargées et laissant passer le faisceau de particules chargées vers l'échantillon.

Dans un deuxième mode de réalisation particulier, l'optique de collection peut comprendre un miroir plan. Ce miroir plan peut être associé à une lentille collectrice disposée en aval dudit miroir plan et renvoyant le rayonnement lumineux, par exemple de manière collimatée. Dans ce cas, le miroir plan peut comprendre une ouverture traversante disposée en regard de la source d'émission de particules chargées et laissant passer le faisceau de particules chargées vers l'échantillon.

Dans un troisième mode de réalisation particulier, l'optique de collection peut comprendre un miroir elliptique, possiblement associé à une lentille collectrice disposée en aval du miroir elliptique. Dans ce cas, le miroir elliptique peut comprendre une ouverture traversante disposée en regard de la source d'émission de particules chargées et laissant passer le faisceau de particules chargées vers l'échantillon.

Plus généralement, l'optique de collection peut comprendre un miroir concave.

Avantageusement, les moyens de positionnement comprennent une platine déplaçable selon au moins une dimension et l'optique de collection est solidaire de ladite platine. Ainsi, en modifiant la position de la platine, il est possible de modifier la position de l'optique de collection.

La platine peut soit être disposée dans la chambre à vide d'un microscope, positionnable de l'intérieur ou de l'extérieur, ou plus avantageusement disposée à l'extérieur de la chambre et positionnable depuis l'extérieur de cette chambre.

La platine peut également se trouver à l'extérieur de la chambre à vide. Dans ce cas, l'optique de collection peut être reliée solidairement à la platine grâce à des moyens de connexion tels qu'une ou plusieurs vis ou un tube traversant la paroi de la chambre à vide de manière à la fois étanche et libre en déplacement selon une ou plusieurs dimensions de l'espace. Une telle connexion à la fois étanche et libre en déplacement peut par exemple être réalisée grâce à un soufflet fixé à une partie de la paroi de la chambre à vide du microscope. Un tel soufflet conserve l'étanchéité de la chambre à vide tout en permettant le déplacement des vis ou du tube qui le traversent.

Les vis micrométriques peuvent être agencées pour permettre le déplacement d'une platine montée solidaire de l'optique de collection.

Dans un mode de réalisation particulièrement avantageux, le système peut comprendre un tube en forme de cylindre, dit cylindre extérieur, par exemple un cylindre de révolution, centré par rapport à l'axe de l'optique de collection, rigidement fixé à ladite optique de collection et monté déplaçable par les moyens de positionnement, ladite optique de collection étant déplacée en déplaçant ledit tube extérieur. Ainsi, dans ce cas, c'est le déplacement du cylindre extérieur qui entraîne le déplacement de l'optique de collection. Par ailleurs, le cylindre extérieur étant solidaire de l'optique de collection, l'axe du cylindre extérieur est aligné avec l'axe de l'optique de collection à tout moment, même lorsqu'ils sont déplacés.

L'optique de collection peut être montée de manière rigide, par exemple au moyen d'une ou plusieurs vis, à l'extrémité du cylindre extérieur du côté de la chambre à vide dans lequel se trouve l'optique de collection. Cette extrémité sera appelée, dans la suite de la description, l'extrémité proximale. L'autre extrémité du cylindre, c'est-à-dire l'extrémité du cylindre du côté des moyens d'analyse, sera appelée l'extrémité distale du cylindre.

Dans un mode de réalisation particulier, le cylindre extérieur peut être montée solidaire sur une platine déplaçable sur une ou plusieurs dimensions, par exemple à l'aide de vis micrométriques. Dans ce cas, les vis micrométriques sont agencées pour réaliser le déplacement de l'ensemble platine fixé au cylindre extérieur à l'extrémité duquel est fixée l'optique de collection.

Le système peut en outre comprendre un tube en forme de cylindre, dit cylindre intérieur, par exemple un cylindre de révolution, disposé centré dans le cylindre extérieur et prévu pour recevoir des moyens optiques d'adaptation du rayonnement lumineux en vue d'injecter ledit rayonnement lumineux directement dans un moyen d'analyse tel qu'un photomultiplicateur, caméra, spectromètre muni d'une caméra ou d'un photomultiplicateur ou via une fibre optique vers un de ces moyens d'analyse. Les moyens optiques d'adaptation peuvent comprendre un ensemble de lentilles et ou de miroirs permettant d'adapter la taille du rayonnement optique aux contraintes spatiales imposées par les parois du tube afin de conserver l'intensité jusqu'au détecteur final. Les différents éléments de l'optique d'adaptation posséderont des ouvertures numériques adaptées les unes par rapport aux autres et par rapport aux systèmes de détection ou de la fibre optique, afin là encore de préserver l'intensité le long du parcours du rayonnement optique. Dans le cas où une fibre optique est utilisée avant le détecteur, son diamètre et son ouverture numérique seront adaptés audit système de détecteur.

La fibre optique est prévue pour réaliser le transport du rayonnement lumineux renvoyé par l'optique de collection jusqu'aux moyens d'analyse.

Le cylindre intérieur peut être monté dans le cylindre extérieur, libre en rotation par rapport audit cylindre extérieur. Ainsi, il est possible d'ajuster l'orientation des éléments optiques se trouvant dans le cylindre intérieur.

En effet, le cylindre intérieur peut comporter tout élément optique utilisé pour les besoins de l'expérimentation, par exemple un polariseur.

Le système de détection de cathodoluminescence peut en outre comprendre des moyens d'analyse du rayonnement lumineux collecté par l'optique de collection.

Les moyens d'analyse peuvent comprendre de manière non exhaustive une caméra CCD et/ou un photomultiplicateur précédés ou non d'un spectromètre.

Dans un mode de réalisation particulier, la fibre optique est reliée directement aux moyens d'analyse.

Dans un mode de réalisation particulier, la fibre optique peut être remplacée par un ensemble de fibres accolées et reliées directement aux moyens d'analyse.

Dans un mode de réalisation particulier, les fibres accolées sont disposées selon un disque en amont, et suivant une ligne en aval. La disposition en disque permet de recueillir le signal même en cas de décentrage léger, la disposition en ligne permet d'optimiser l'intensité et la résolution spectrale lorsque l'ensemble de fibres est placé en entrée d'un spectromètre optique par exemple.

Le système peut comprendre, en aval de l'optique de collection, des moyens optiques d'adaptation du rayonnement lumineux en vue d'injecter ledit rayonnement lumineux dans une fibre optique ou un détecteur, tels que par exemple une lentille permettant d'adapter la taille du rayonnement lumineux et l'angle d'incidence à l'entrée d'une fibre optique ou d'un détecteur.

Avantageusement, les moyens d'adaptation peuvent comprendre un diaphragme arrangé pour laisser passer le rayonnement lumineux provenant de l'optique de collection vers les moyens d'analyse et bloquer au moins un signal optique indésirable. En effet, dans un mode de réalisation particulier, un diaphragme peut être placé centré le long de l'axe optique, permettant de laisser passer les rayonnement lumineux émis à l'entourage du point focal de l'optique de collection (sur l'échantillon) et permettant de filtrer les rayonnements lumineux émis à partir d'autres régions de l'échantillon.

En effet, le faisceau de particules chargées, en frappant l'échantillon, peut éjecter différentes particules comme des électrons et des ions dits secondaires et des particules chargées dites rétrodiffusées. Ces particules secondaires et rétrodiffusées peuvent à leur tour frapper différents objets à l'intérieur du microscope (et loin du point focal de l'optique de collection) et causer l'émission de rayonnement lumineux non pertinent, que l'on filtrera ainsi avec un diaphragme.

Avantageusement, les fibres accolées, disposées selon un disque en amont, ont un diamètre réduit déterminé pour faire office de diaphragme.

Le système de détection de cathodoluminescence peut également être souple et facile à entretenir. Dans cette optique, dans le système de détection de cathodoluminescence, l'optique de collection peut être disposée dans une chambre ou règne une pression inférieure à la pression atmosphérique, dite chambre à vide, et les moyens d'adaptation sont disposés dans un environnement où règne une pression supérieure à la pression de ladite chambre, par exemple la pression atmosphérique, ledit système comprenant en outre des moyens d'étanchéité disposés entre ladite chambre et lesdits moyens d'adaptation pour maintenir la pression de ladite chambre.

Dans un mode de réalisation particulier du système de détection de cathodoluminescence, l'optique de collection est montée, de manière solidaire, à l'extrémité proximale du cylindre extérieur de manière bien centrée et coaxiale à l'axe optique de l'optique de collection. Le cylindre extérieur comporte du côté de son extrémité proximale une fenêtre d'étanchéité transparente et agencée pour préserver l'étanchéité de la chambre à vide. Le cylindre intérieur est inséré dans le cylindre extérieur de manière démontable et éventuellement libre en rotation. Ce dernier est monté coaxial avec le cylindre extérieur et est donc forcément centré par rapport à l'axe optique de l'optique de collection. Les moyens d'adaptation, ainsi que l'entrée de la fibre optique sont disposés dans le cylindre intérieur et se trouvent donc à une pression atmosphérique. Ces éléments sont facilement accessibles par un opérateur puisque le cylindre intérieur est démontable. Le cylindre intérieur peut en outre comprendre tout élément optique tel que par exemple un polariseur.

Le cylindre extérieur est entouré d'au moins un moyen d'étanchéité autorisant le déplacement du cylindre extérieur dans les trois directions de l'espace tout en préservant l'étanchéité de la chambre à vide dans laquelle se trouve l'optique de collection. Un tel moyen d'étanchéité peut par exemple comprendre un soufflet étanche autorisant le déplacement du cylindre dans les trois directions et monté sur une paroi de la chambre à vide autour ou au niveau d'une ouverture réalisée dans cette paroi dans la direction suivie par le rayonnement lumineux renvoyé par l'optique de collection vers les moyens d'analyse.

Le cylindre extérieur est monté solidairement sur une platine. Cette platine est déplaçable dans les trois directions de l'espace grâce à des vis micrométriques. Ainsi en déplaçant la platine l'opérateur peut déplacer le cylindre extérieur et l'optique de collection.

Lors du déplacement de l'ensemble platine, cylindre extérieur et optique de collection, l'étanchéité de la chambre à vide est conservée grâce au soufflet entourant le cylindre extérieur et fixé à la paroi de la chambre à vide, et à la fenêtre d'étanchéité disposée dans le cylindre extérieur.

L'optique de collection est solidaire du cylindre extérieur. Ce dernier est centré par rapport à l'axe optique de l'optique de collection. Le cylindre intérieur est centré par rapport au cylindre extérieur. Ainsi tous les éléments se trouvant dans le cylindre intérieur sont centrés par rapport à l'axe optique de l'optique de collection. L'ensemble optique de collection+cylindre extérieur+cylindre intérieur étant solidaire, ces derniers restent toujours bien centrés à tout moment.

Avantageusement, les éléments se trouvant dans le cylindre intérieur sont placés au plus près de l'optique de collection pour réduire les effets d'un possible désalignement léger entre l'axe optique de l'optique de collection et le centre du cylindre intérieur.

Avantageusement, ledit cylindre extérieur a un diamètre interne suffisamment grand pour permettre l'utilisation des éléments optiques, tels que des lentilles, ou des détecteurs tels que des photomultiplicateurs et des caméras CCD, à l'intérieur du cylindre extérieur.

Avantageusement, l'optique de collection peut avoir une surface conductrice isolée électriquement par rapport au reste du dispositif et du microscope. L'optique de collection peut ainsi être mise à un potentiel électrique faible par rapport à la masse du microscope, éventuellement via un fil électrique accessible de l'extérieur du microscope via un passage électrique étanche, pour pouvoir ainsi détecter, par l'apparition d'un courant électrique, un contact quelconque avec le microscope. En effet, l'optique de collection se trouve dans un espace encombré et ne doit pas s'écraser contre les éléments standard du microscope, tels que l'échantillon ou la pièce polaire. Ces mouvements doivent être surveillés avec attention. En mesurant le courant électrique entre l'optique de collection et le microscope, il est possible de déterminer l'occurrence d'un contact léger entre l'optique de collection et le microscope.

Avantageusement, le système peut en outre comprendre une source d'émission d'un faisceau lumineux se propageant dans le sens inverse du sens de propagation du rayonnement lumineux détecté en provenance de l'échantillon et reçu par l'optique de collection, ledit faisceau lumineux étant dirigé vers l'échantillon par l'optique de collection.

En effet, le système de cathodoluminescence peut en outre être utilisé pour injecter de la lumière sur l'échantillon. Dans ce cas, le système de cathodoluminescence comprend une source d'émission d'un faisceau lumineux à la place ou en plus du système de détection. Cette source est alors arrangée pour émettre un faisceau lumineux dans le sens inverse du sens de propagation du rayonnement lumineux détecté, c'est-à-dire de l'aval vers l'amont. La source de lumière est focalisée sur l'échantillon, les zones d'exposition aux particules chargées et au faisceau lumineux étant ainsi superposées. La source de lumière peut être une source de lumière spatialement cohérente, par exemple un laser, de sorte que la taille du faisceau lumineux frappant l'échantillon n'est limitée que par les lois de l'optique géométrique et de la diffraction pour ainsi optimiser la densité de puissance reçue par l'échantillon.

Avantageusement, le système peut en outre être utilisé avec un séparateur de rayonnement lumineux et être utilisé pour injecter de la lumière sur l'échantillon et en même temps collecter la lumière émise par l'échantillon.

En effet, le système de cathodoluminescence peut en outre être utilisé pour détecter le rayonnement lumineux émis par l'échantillon par l'effet de photoluminescence, c'est-à-dire quand un faisceau lumineux frappe un objet, ce qui le pousse à émettre à son tour un rayonnement lumineux. Ce séparateur est alors arrangé pour permettre l'injection d'un faisceau lumineux de l'aval vers l'amont et la détection simultanée de rayonnement lumineux de l'amont vers l'aval. La petite taille du faisceau injecté peut permettre l'excitation d'une petite partie de l'échantillon qui peut être en même temps imagée avec le faisceau de particules chargées du microscope. Le rayonnement lumineux émis par l'échantillon lors de l'injection de lumière peut être analysé de la même façon que le rayonnement lumineux émis suite à l'interaction de particules chargées.

Selon l'invention, le système de cathodoluminescence permet de collecter le rayonnement lumineux issu de l'échantillon éclairé par un faisceau de particules chargées de taille nanométrique ou sub-nanométrique éventuellement balayé à la surface de l'échantillon et de le transporter jusqu'au moyens d'analyse tout en conservant plus d'intensité lumineuse et de résolution spectrale comparé aux systèmes de cathodoluminescence de l'état de la technique.

Selon l'invention un tel système de cathodoluminescence comprend :

- une source de particules chargées agencée pour éclairer un échantillon avec un faisceau de particules chargées, et
- un chemin optique comprenant au moins deux éléments optiques prévus pour collecter et transporter un rayonnement lumineux provenant dudit échantillon éclairé vers des moyens d'analyse ;

ledit système étant caractérisé en ce que chaque élément optique dudit chemin optique est choisi de sorte que :

- l'angle maximal de sortie dudit élément optique soit inférieur ou égal à 120% de l'angle maximal d'acceptance de l'élément optique suivant ; et
- le diamètre du rayonnement provenant dudit élément optique dans le plan d'entrée de l'élément optique suivant soit inférieur ou égal à 120% du diamètre utile d'entrée de l'élément optique suivant.

Ainsi, selon l'invention chaque élément transmet au moins 60% du signal lumineux. Seule une perte de 20% du signal lumineux a lieu au niveau de chaque élément optique du chemin optique.

Un tel système de cathodoluminescence permet de collecter le rayonnement lumineux issu de l'échantillon éclairé et de le transporter jusqu'au moyens d'analyse tout en conservant plus d'intensité lumineuse comparé aux systèmes de cathodoluminescence de l'état de la technique.

Selon une version préférée du système de l'invention, chaque élément optique du chemin optique est choisi de sorte que l'angle maximal de sortie d'un élément optique est inférieur ou égal à l'angle maximal d'acceptance de l'élément optique suivant. Ainsi, l'angle de sortie d'un élément optique est adapté et le rayonnement lumineux sortant d'un élément optique arrive à l'élément optique suivant avec un angle tel que la totalité du rayonnement lumineux entre dans l'élément optique suivant.

Toujours selon une version préférée du système selon l'invention, chaque élément optique du chemin optique est choisi de sorte que le diamètre du rayonnement provenant d'un élément optique dans le plan d'entrée de l'élément optique suivant est inférieur ou égal au diamètre utile d'entrée de l'élément optique suivant. Ainsi, le rayonnement lumineux arrivant à l'élément optique suivant entre totalement dans l'élément optique suivant.

Dans la combinaison de ces deux versions préférées du système selon l'invention, cette version préférée de l'invention, le signal lumineux est transmis d'un élément optique à l'autre sans aucune perte d'intensité autre que celle due à l'absorption ou la diffusion des systèmes optiques et la totalité de cette intensité du signal lumineux est conservée sur l'ensemble du chemin optique.

Avantageusement, lorsque le chemin optique comprend N éléments optiques, chaque élément optique du chemin optique peut être positionné de sorte que le décalage d'un élément optique par rapport au centre de l'élément optique précédent vérifie la relation suivante :

$$Ds_i/2 \leq 1.2De_{i+1}/2 - \Delta_{i+1} \quad pour \ i=1...N\text{-}1$$

avec :

- $\Delta_{i+1}$ le décalage de l'élément optique i+1 par rapport au centre de l'élément optique i,
- $De_{i+1}$ le diamètre utile d'entrée de l'élément i+1,
- $Ds_i$ le diamètre du rayonnement provenant de l'élément i mesuré à l'entrée de l'élément i+1.

Un tel système permet de s'assurer un positionnement amélioré par rapport aux systèmes de l'état de la technique et ainsi de véhiculer le rayonnement lumineux sur l'ensemble du chemin optique avec peu de perte.

Dans une version préférée du système selon l'invention, chaque élément optique du chemin optique peut être positionné de sorte que le décalage d'un élément optique par rapport au centre de l'élément optique précédent vérifie la relation suivante :

$$Ds_i/2 \leq De_{i+1}/2 - \Delta_{i+1} \quad pour \ i=1...N\text{-}1$$

avec :

- $\Delta_{i+1}$ le décalage de l'élément optique i+1 par rapport au centre de l'élément optique i,
- $De_{i+1}$ le diamètre utile d'entrée,
- $Ds_i$ le diamètre de du faisceau provenant de l'élément i mesuré à l'entrée de l'élément i+1.

Un tel système permet d'obtenir un positionnement des éléments optique tel que tout le rayonnement sortant d'un élément optique entre dans l'élément optique suivant sans perte autre que celles induites par absorption ou diffusion car aucun élément optique ne présente un décalage par rapport à l'élément optique précédent tel qu'une partie du rayonnement soit perdue.

Selon l'invention, un des éléments optiques du chemin optique peut être un spectromètre, et plus particulièrement un spectromètre comprenant un élément focalisant à son entrée.

Dans ce cas, le spectromètre et les autres éléments optiques du chemin optique peuvent être choisis de sorte que la largeur du faisceau à l'entrée du spectromètre suivant la direction dispersive soit inférieure ou égale à 10 fois le diamètre limite à l'entrée du spectromètre en dessous duquel la résolution du spectromètre ne dépend plus du diamètre de la taille du rayonnement lumineux à l'entrée du spectromètre. La valeur d'un tel diamètre limite est une donnée fournie par le constructeur du spectromètre et dépend en grande partie de son grandissement suivant la direction dispersive.

Ainsi, le système selon l'invention permet de véhiculer le rayonnement lumineux jusqu'au spectromètre sans perte d'intensité, car les diamètres et les angles sont adaptés, tout en assurant la résolution spectrale optimale pour un spectromètre donné.

Toujours dans le cas où un des éléments du chemin optique est un spectromètre, le spectromètre et les autres éléments optiques du chemin optique peuvent préférentiellement être choisis de sorte que la largeur du faisceau à l'entrée du spectromètre dans la direction dispersive soit inférieure ou égale au diamètre limite à l'entrée du spectromètre en dessous duquel la résolution du spectromètre ne dépend plus du diamètre de la taille du rayonnement lumineux à l'entrée du spectromètre.

Ainsi, le système selon l'invention permet de véhiculer le rayonnement lumineux jusqu'au spectromètre sans perte d'intensité, car les diamètres et les angles sont adaptés, tout en assurant une résolution spectrale optimale pour un spectromètre donné.

Dans un mode de réalisation particulier, l'élément optique précédent le spectromètre peut comprendre une fibre optique dont la sortie est positionnée ou imagée à l'entrée du spectromètre.

Dans ce cas, la fibre optique et l'élément optique précédent la fibre optique peuvent être choisis de sorte que :

- le diamètre du faisceau provenant de l'élément optique précédent mesuré à l'entrée de la fibre soit inférieur ou égal à 120 %, préférentiellement inférieur ou égal à 100%, du diamètre utile de la fibre optique, et
- l'angle d'entrée maximum du faisceau provenant de l'élément optique précédent soit inférieur ou égale à 120 %, préférentiellement inférieur ou égal à 100%, de l'angle limite d'incidence de ladite fibre optique.

Ainsi, le chemin optique est parfaitement adapté pour que l'ensemble du rayonnement lumineux entre dans la fibre optique dans des conditions telles que l'ensemble du rayonnement optique est transporté jusqu'au spectromètre sans perte ou avec des pertes négligeables.

Dans une version particulièrement avantageuse et préférée de l'invention, l'élément optique précédant le spectromètre peut comprendre une pluralité de fibres optiques composant un faisceau de fibres optiques, les fibres dudit faisceau étant alignées, du côté dudit spectromètre, perpendiculairement à l'axe de dispersion dans le plan d'entrée dudit spectromètre, la somme des diamètres de l'ensemble des fibres est préférentiellement inférieure ou égale à la taille du détecteur suivant la direction non dispersive divisée par le grandissement du spectromètre suivant la direction non dispersive. Chaque fibre optique composant le faisceau de fibres optiques est choisie, de sorte que :

- le diamètre du faisceau provenant de l'élément optique précédent à l'entrée de la fibre soit inférieur ou égal à 120 %, préférentiellement à 100%, du diamètre utile de la fibre optique, et
- le diamètre utile de chaque fibre ou de leur image à l'entrée du spectromètre soit inférieur ou égal à 120%, préférentiellement à 100%, du diamètre limite à l'entrée dudit spectromètre en dessous duquel la résolution dudit spectromètre ne dépend plus du diamètre dudit rayonnement lumineux à l'entrée dudit spectromètre,
- l'angle d'entrée maximum du faisceau provenant de l'élément optique précédent soit inférieur ou égal à 120 %, préférentiellement à 100%, de l'angle limite d'incidence de ladite fibre optique, et
- l'angle de sortie du rayonnement provenant des fibres à l'entrée du spectromètre est inférieur ou égal à 120%, préférentiellement à 100%, de l'angle limite d'entrée dudit spectromètre.

Ainsi, cette construction permet de s'assurer que quel que soit le décalage du dernier élément optique selon n'importe quel axe de l'espace, au moins une fibre optique est positionnée pour recevoir la totalité du rayonnement, ou presque la totalité du rayonnement. De plus, le faisceau de fibres étant orienté perpendiculairement à la direction non dispersive du spectromètre, la résolution spectrale sera dépendante de la largeur des fibres et non du diamètre du faisceau, bien que l'intensité collectée dépende de la somme des aires des fibres illuminées. Un tel système est particulièrement efficace pour corriger les erreurs, dites dynamiques, dues à des désalignements causés par exemple par un balayage du faisceau de particules chargées sur l'échantillon ou des erreurs d'alignements systématiques.

Dans un exemple de réalisation particulier, le faisceau de fibres peut être compact et préférentiellement hexagonale en entrée.

Le diamètre de chacune des fibres du faisceau de fibres peut être identique.

Par ailleurs, dans une version préférée mais non limitative, le rapport entre le diamètre total du faisceau de fibres et le diamètre d'une fibre peut être compris entre 3 et 30.

Avantageusement, le premier élément optique peut comprendre un élément de collection qui peut être soit un miroir courbe soit un miroir plan associé à une lentille pour collecter le rayonnement lumineux provenant de l'échantillon. Pour s'insérer dans la pièce polaire du microscope dans le lequel est inséré le système de cathodoluminescence et permettant de former le faisceau de particules chargées, et sachant que l'espace dans ces pièces polaires est d'autant plus faible que la résolution spatiale désirée est meilleure, cet élément de collection présente avantageusement une épaisseur totale comprise entre 0.5 et 10 mm, et préférentiellement comprise entre 1 et 8 mm, pour permettre une collection du rayonnement lumineux provenant de l'échantillon selon un angle solide le plus grand possible.

Pour améliorer la collection du rayonnement lumineux provenant de l'échantillon, le premier élément optique réalisant la collection du rayonnement lumineux peut avantageusement présenter :

- un paramètre « p » compris entre 0.5 et 20 mm, plus préférentiellement entre 1 et 7 mm, et encore plus préférentiellement entre 1.5 et 5 mm, encore plus préférentiellement entre 1 et 3 mm, ou encore un paramètre « p » de l'ordre de 2 mm à ±1.5 mm ; ou
- une focale « f » comprise entre 0.25 et 10 mm, plus préférentiellement entre 0.5 et 3.5 mm, et encore plus préférentiellement entre 0.75 et 2.5 mm.

Selon un mode de réalisation avantageux, les éléments optiques du chemin optique peuvent être positionnés de sorte que la précision du déplacement dans au moins une des deux directions de l'espace perpendiculaires à l'axe optique est meilleure ou égale :

- à la taille à l'entrée du spectromètre, c'est-à-dire la dimension du pixel du détecteur divisé par le grandissement du spectromètre, divisé par le grandissement total réalisé sur le chemin optique entre la source et l'entrée du spectromètre, ou

- lorsque l'élément optique précédent le spectromètre est une fibre ou un faisceau de fibres optiques, au diamètre de la fibre optique, ou de la plus grande des fibres dans le faisceau, divisé par le grandissement total réalisé sur le chemin optique jusqu'à l'entrée de la fibre optique ou du faisceau de fibres optiques.

Dans un tel système, la précision de l'alignement dans le plan perpendiculaire à l'axe optique est telle que les désalignements résiduels ne diminuent essentiellement pas les performances décrites (conservation de l'intensité collectée jusqu'au détecteur, résolution spectrale optimale).

Avantageusement, les éléments optiques du chemin optique peuvent en outre être positionnés de sorte que la précision dans la direction de l'axe optique est supérieure ou égale :

- à la taille de l'entrée du spectromètre, c'est-à-dire la dimension du pixel du détecteur divisé par le grandissement du spectromètre, divisée par le grandissement réalisé sur le chemin optique entre la source et le plan d'entrée du spectromètre et par l'angle maximal d'acceptance du premier élément optique, ou
- lorsque le dernier élément optique est une fibre ou un faisceau de fibres optiques, au diamètre de la fibre optique, ou le diamètre de la plus grande fibre dans le faisceau, divisé par le grandissement réalisé sur le chemin optique entre la source et le plan d'entrée de la fibre optique ou du faisceau de fibres et par l'angle maximal d'acceptance du premier élément optique.

Dans un tel système, la précision de l'alignement le long de l'axe optique est telle que les désalignements résiduels ne diminuent essentiellement pas les performances décrites : conservation de l'intensité collectée jusqu'au détecteur, résolution spectrale optimale, etc.

Dans le système selon l'invention, le chemin optique comprend au moins deux éléments optiques, au moins un premier élément optique, dit optique de collection, pour collecter un rayonnement lumineux provenant de l'échantillon éclairé et au moins un deuxième élément optique, dit optique d'adaptation, pour transporter le rayonnement collecté vers des moyens d'analyse.

Ce système peut en outre comprendre des moyens de translation, pour translater l'optique de collection linéairement et indépendamment selon trois axes différents de l'espace. Ainsi, le déplacement de l'optique de collection est réalisé selon chaque axe indépendamment des autres axes. Par ailleurs, le déplacement sur chaque axe est une translation.

Dans une version particulière du système selon l'invention, tout ou partie de l'optique d'adaptation peut être disposée dans un environnement où règne une pression supérieure à la pression dans une chambre à vide dans laquelle est disposée l'optique de collection.

Bien entendu les deux aspects présentés ci-dessus sont indépendants l'un de l'autre, mais peuvent être combinés sur un unique système de cathodoluminescence. L'invention concerne également un tel système de cathodoluminescence combinant les deux aspects décrits dans la présente demande.

L'invention propose en outre un microscope comprenant :

- une source d'émission d'un faisceau de particules chargées, et
- un système de détection de cathodoluminescence selon l'invention.

Avantageusement le microscope selon l'invention peut en outre comprendre au moins :

- un détecteur fond clair,
- un détecteur fond noir,
- un détecteur EELS,
- une caméra pour l'imagerie ou la diffraction, ou
- un détecteur EDX.

D'autres avantages et caractéristiques de l'invention apparaîtront à l'examen de la description détaillée d'un mode de mise en oeuvre, nullement limitatif, et des dessins annexés sur lesquels :

- la figure 1 est une représentation schématique du principe d'un microscope selon l'invention mettant en oeuvre un système de détection de cathodoluminescence selon l'invention ;
- la figure 2 est une représentation schématique d'un exemple d'optique de collection mis en oeuvre dans le système de cathodoluminescence selon l'invention ;
- les figures 3 à 5 sont des représentations schématiques d'un premier aspect du système de détection de cathodoluminescence mis en oeuvre par le microscope de la figure 1 ;
- les figures 6 et 7 sont des représentations schématiques d'un deuxième aspect du système de détection de cathodoluminescence mis en oeuvre par le microscope de la figure 1 ;
- la figure 8 est une représentation schématique d'un premier exemple du chemin optique d'un système de cathodoluminescence selon l'invention ;
- la figure 9 est une représentation schématique d'un deuxième exemple du chemin optique d'un système de cathodoluminescence selon l'invention comprenant une fibre optique ;
- les figures 10 et 11 sont des représentations schématiques selon différentes vues d'un troisième exemple du chemin optique d'un système de cathodoluminescence selon l'invention comprenant un faisceau de fibres optiques ; et

- les figures 12 et 13 sont des représentations schématiques de deux configurations dans lesquelles le rayonnement lumineux arrive à l'entrée du faisceau de fibres optiques en deux positions différentes dans le système des figures 10 et 11.

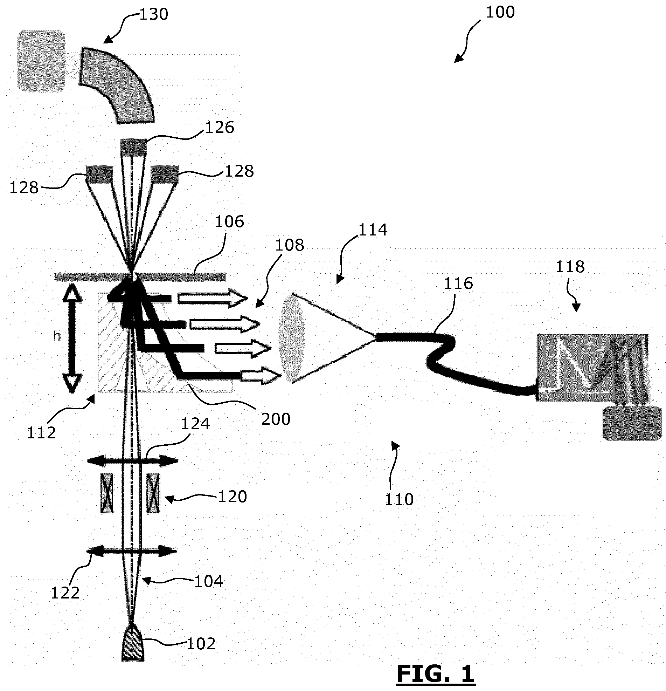

La figure 1 est une représentation schématique du principe du système de détection de cathodoluminescence mis en oeuvre par un microscope 100.

Le microscope 100 comprend une source 102 d'émission d'un faisceau 104 d'électrons sur un échantillon 106. En réponse à ce faisceau d'électrons 104, l'échantillon 106 émet un rayonnement lumineux 108 pouvant comprendre des longueurs d'onde allant de l'infrarouge aux ultraviolets.

Le rayonnement lumineux 108 est ensuite collecté et analysé par un système 110 de détection de cathodoluminescence.

Le système 110 de détection de cathodoluminescence comprend une optique de collection 112, des moyens 114 d'adaptation du diamètre (respectivement de l'angle) du faisceau lumineux 108 au diamètre (respectivement à l'ouverture numérique) d'une fibre optique 116 et des moyens d'analyse 118. L'optique de collection 112 a pour rôle de collecter le rayonnement lumineux 108 émis par l'échantillon 106, la fibre optique 116 a pour rôle de transporter le rayonnement lumineux 108 collecté par l'optique collection 112 jusqu'aux moyens d'analyse 118. Cependant, il est nécessaire d'utiliser des moyens d'adaptation 114 pour adapter le rayonnement lumineux 108 à la sortie de l'optique collection 112 à l'entrée de la fibre optique 116 tout en préservant l'intensité du signal ainsi que sa résolution spectrale.

Les moyens d'analyse 118 peuvent comprendre un spectromètre, une caméra CCD ou un photomultiplicateur prévu pour analyser le rayonnement lumineux 108 transporté par la fibre optique 116.

Le microscope 100 comprend en outre une bobine de balayage 120 disposée entre une lentille condenseur 122 positionnée du côté de la source d'électrons 102 et une lentille objectif 124 positionnée du côté opposé. La bobine de balayage 120 permet de balayer la surface de l'échantillon 106 avec le faisceau d'électrons 104 pour réaliser une étude spectroscopique de l'échantillon 106.

Le microscope peut en outre comprendre un ou plusieurs détecteurs fond clair 126, un ou plusieurs détecteurs fond noir 128 ainsi qu'un détecteur EELS 130.

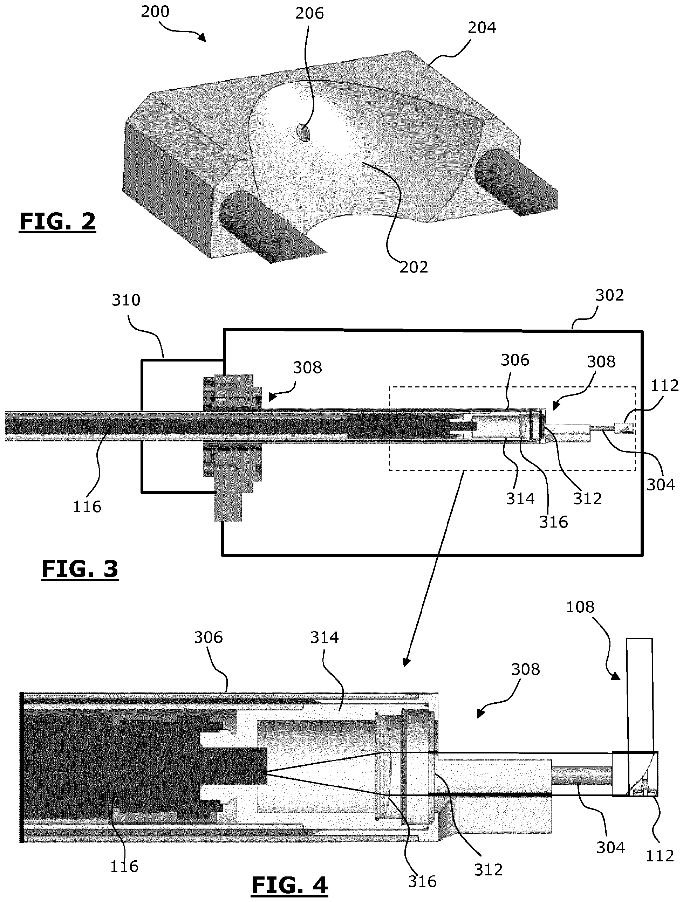

Dans l'exemple représenté sur la figure 1, l'optique de collection 112 comprend un miroir parabolique 200 tel que représenté en figure 2. Le miroir parabolique comprend une surface parabolique 202 réfléchissante taillée dans un bloc 204. Le miroir parabolique 200 comporte une ouverture traversante 206. Cette ouverture 206 est disposée en regard de la source d'émission 102 du faisceau d'électrons 104. Le faisceau d'électrons 104 traverse cette ouverture 206 pour atteindre l'échantillon 106. Le rayonnement lumineux émis par l'échantillon est ensuite collecté par la surface parabolique 202. Le positionnement précis de l'ouverture 206 en face de la source d'émission est très important pour optimiser la brillance et la résolution du rayonnement lumineux collecté par la surface parabolique 204.

Dans un autre exemple de réalisation non représenté, l'optique de collection 112 peut comprendre un miroir plan associé à une lentille collectrice ou un miroir elliptique éventuellement associé à une lentille collectrice à la place du miroir parabolique.

## Premier aspect

Nous allons maintenant décrire un premier aspect d'un système de cathodoluminescence pouvant être combiné au système de cathodoluminescence selon l'invention, en référence aux figures 3-5.

La figure 3 est une représentation partielle du système de collection par rapport à la chambre à vide d'un microscope.

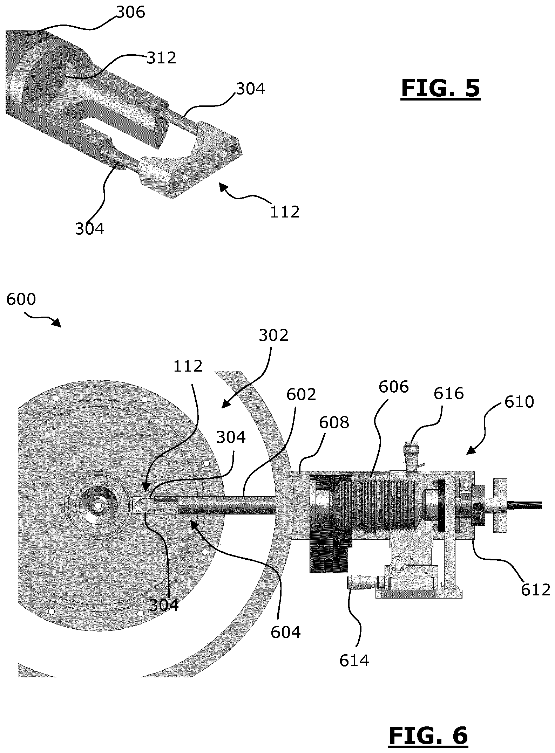

La figure 4 est une représentation plus détaillée en coupe d'une région de la figure 3 et la figure 5 est une représentation selon une vue isométrique de la même région.

Selon ce premier aspect l'optique de collection 112 est prévue pour être disposée dans une chambre à vide 302 du microscope et les moyens d'adaptation 114 ainsi que la fibre optique 116 et les moyens d'analyse 118 sont disposés dans un environnement à la pression atmosphérique. En d'autres termes, les moyens d'adaptation 114, la fibre optique et les moyens d'analyse sont déportés hors de la chambre à vide 302 du microscope.

Pour ce faire, dans l'exemple représenté sur les figures 3 à 5, l'optique de collection 112, qui est un miroir parabolique tel que représenté en figure 2, est reliée solidairement à l'aide de deux vis 304, à un premier cylindre 306, dit cylindre extérieur, au niveau de son extrémité proximale 308. L'optique de collection 112 est reliée au cylindre extérieur de sorte que l'axe optique de l'optique de collection 112 se confonde avec l'axe de symétrie du cylindre extérieur 306.

Ce cylindre extérieur 306 pénètre dans la chambre à vide grâce à une ouverture 308 formée dans une paroi de la chambre à vide. Cette ouverture 308 est disposée en regard du rayonnement lumineux renvoyé par l'optique de collection 112.

Le cylindre extérieur 306 et la paroi de la chambre à vide 302 sont maintenus ensemble par un dispositif 310 étanche préservant le niveau de la pression qui règne dans la chambre à vide.

Le cylindre extérieur 306 comporte au niveau de son extrémité proximale 308, c'est-à-dire l'extrémité sur laquelle est fixée solidairement l'optique de collection 112, une fenêtre 312 d'étanchéité transparente préservant le niveau de la pression qui règne dans la chambre à vide 302 tout en laissant passer le rayonnement lumineux collecté et renvoyé par l'optique de collection 112.

Ainsi, en aval de la fenêtre d'étanchéité, l'intérieur du cylindre extérieur 306 est étanchement séparé de la chambre à vide et il y règne une pression atmosphérique.

Un deuxième cylindre 314, dit cylindre intérieur, est disposé à l'intérieur du cylindre extérieur 306 en aval de la fenêtre d'étanchéité 312, c'est-à-dire dans la partie où règne une pression atmosphérique. Le cylindre intérieur 314 a son axe de symétrie confondu avec l'axe de symétrie du cylindre extérieur 306 et est donc parfaitement aligné avec l'axe optique de l'optique de collection 112. Le cylindre intérieur 314 est disposé dans le cylindre extérieur 306 de manière démontable et libre en rotation.

Les moyens d'adaptation 114 sont disposés dans ce cylindre intérieur 314. Dans l'exemple présent, représenté en figures 3 et 4, les moyens d'adaptation 114 comprennent une lentille collectrice 316 convergente disposée au niveau de l'extrémité proximale du cylindre intérieur 314. Cette lentille 316 permet d'adapter la largeur du rayonnement lumineux 108 à l'entrée de la fibre optique 116.

L'entrée de la fibre optique est également disposée à l'intérieur du cylindre intérieur en aval de la lentille collectrice 316 et centrée très précisément par rapport à l'axe optique de la lentille collectrice 316.

Le cylindre intérieur peut également comprendre tout élément optique nécessaire pour l'étude de l'échantillon, par exemple un polariseur.

Le fait que le cylindre intérieur soit libre en rotation permet de modifier l'orientation des différents éléments optiques sans avoir à les retirer.

Ainsi, selon ce premier aspect, il est possible d'accéder facilement aux éléments optiques composants les moyens d'adaptation ainsi qu'à l'entrée de la fibre optique pour les changer, les réparer ou les repositionner.

**Deuxième aspect**

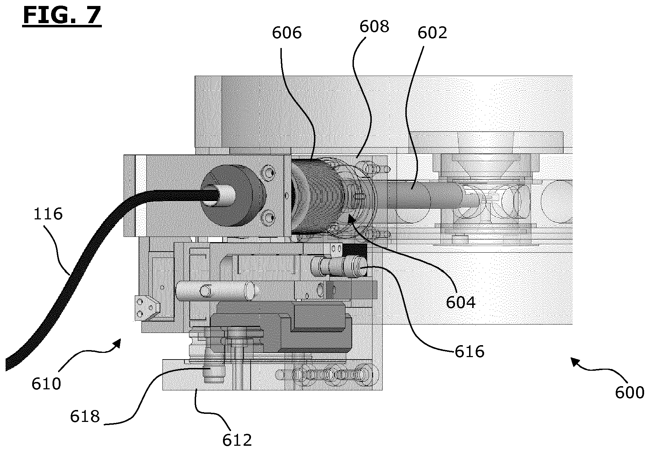

Nous allons maintenant décrire un deuxième aspect d'un système de cathodoluminescence pouvant être combiné au système de cathodoluminescence selon l'invention, en référence aux figures 6 et 7.

La figure 6 est une représentation partielle vue de dessus d'un microscope 600 mettant en oeuvre un système de détection de cathodoluminescence selon ce deuxième aspect. Sur la figure 6, l'optique de collection est complètement rétractée, permettant une utilisation standard du microscope. Elle ne correspond pas à une vue du système de détection de cathodoluminescence en fonctionnement. La figure 7 est une représentation du microscope de la figure 6 selon une vue de côté.

L'optique de collection 112 est liée solidairement à un cylindre 602 grâce à deux vis 304 au niveau de l'extrémité proximale 604 du cylindre 602. L'optique de collection 112 est située dans la chambre à vide 302 du microscope 600. Le cylindre 602 peut également comprendre les moyens optiques d'adaptation 114 et l'entrée de la fibre optique 116, qui peuvent par exemple être disposés dans un deuxième cylindre inséré dans le cylindre 602 de manière démontable, libre en rotation et monté de sorte que l'axe de symétrie se confonde avec l'axe de symétrie du cylindre 602. Le cylindre 602 peut être le cylindre extérieur 306 et comprendre le cylindre intérieur 314, ainsi que décrits plus haut.

Le cylindre 602 pénètre dans la chambre à vide 302 grâce à une ouverture 604 formée dans une paroi de la chambre à vide. Cette ouverture 604 est disposée en regard du rayonnement lumineux renvoyé par l'optique de collection 112. Le diamètre de cette ouverture est supérieur au diamètre extérieur du cylindre 602 de manière à permettre le déplacement du cylindre extérieur selon les trois dimensions de l'espace. Cette ouverture 604 peut être l'ouverture 308 décrite plus haut.

Un soufflet 606 est fixé au cylindre 602 et entoure le cylindre 602 de manière étanche. Ce soufflet est par ailleurs fixé de manière étanche sur la paroi de la chambre à vide 302, autour de l'ouverture 602, grâce à une pièce de liaison 608 épousant la forme extérieure de la paroi de la chambre à vide autour de l'ouverture 602. Ainsi, la liaison du soufflet 606 avec le cylindre 602 est étanche tout comme la liaison du soufflet 606 avec la paroi de la chambre à vide 302. Le soufflet 606 autorise le déplacement du cylindre 606 dans les trois directions de l'espace tout en préservant à tout moment l'étanchéité au niveau de chacune des ses liaisons avec d'une part le cylindre 602 et d'autre part la paroi de la chambre à vide 302.

Le cylindre 602 comporte une fenêtre d'étanchéité (non représentée sur les figures 6-7). Cette fenêtre d'étanchéité permet de préserver l'étanchéité de la chambre à vide 302. Cette fenêtre d'étanchéité peut être disposée en amont ou en aval des moyens optiques d'adaptation 114 et de l'entrée de la fibre optique 116. Cette fenêtre d'étanchéité peut par exemple être la fenêtre d'étanchéité 312 des figures 3-5, lorsque les deux aspects du système de cathodoluminescence décrits dans la présente demande sont combinés.

Le cylindre 602 est monté solidairement sur un dispositif de déplacement tridimensionnel 610 du côté de son extrémité distale 612, c'est-à-dire son extrémité du côté opposé à l'optique de collection 112. Ce dispositif 610 de déplacement tridimensionnel est posé sur une platine 612 montée déplaçable sur la paroi de la chambre à vide 302. Le dispositif 610 comprend trois vis micrométriques 614, 616 et 618 permettant de déplacer le cylindre 602 selon les trois dimensions de l'espace.

L'optique de collection 112 étant solidaire du cylindre 602, le déplacement du cylindre 602 entraîne le déplacement de l'optique de collection 112. Ainsi, grâce à ce deuxième aspect du système de détection de cathodoluminescence, il est possible pour l'opérateur de déplacer l'optique de collection depuis l'extérieur du microscope pour mieux la positionner par rapport à la source d'émission d'électrons et par rapport à l'échantillon, pour améliorer la conservation de l'intensité du rayonnement lumineux collecté en aval de l'optique de collection ainsi que la résolution spectrale du signal lumineux.

Il est clair pour l'homme du métier, à la lecture de la présente demande, que les premier et deuxième aspects du système de détection de cathodoluminescence peuvent être combinés. Tel qu'indiqué plus haut, le cylindre 602 représenté sur la figure 6 et 7 peut être remplacé par le cylindre extérieur 306 des figures 3 à 5 comprenant la fenêtre d'étanchéité 312, le cylindre intérieur 314 dans lequel sont disposés les moyens d'adaptation 114 (en particulier la lentille collectrice 316), et l'entrée de la fibre optique 116. En combinant le premier et le deuxième aspect, il est possible d'obtenir un système de détection de cathodoluminescence à la fois souple et réglable et permettant d'optimiser l'intensité lumineuse collectée, son transport vers les moyens d'analyse tout en conservant une résolution spectrale optimale par des moyens communs et faciles mettre en oeuvre.

**Troisième aspect**

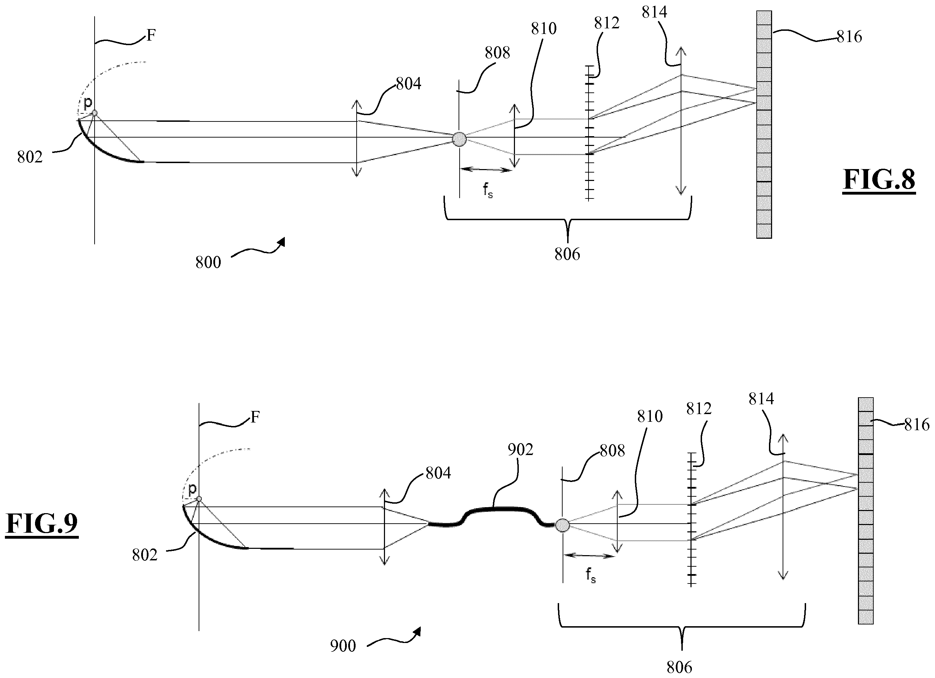

La figure 8 est une représentation schématique d'un premier exemple du chemin optique d'un système de cathodoluminescence selon l'invention.

Le chemin optique 800 de la figure 8 comprend en tant que moyen de collection un miroir parabolique 802 qui peut être identique au miroir parabolique 200 de la figure 2 qui collecte le rayonnement lumineux provenant d'un échantillon éclairé par un faisceau de particules.

Le chemin optique 800 comprend en tant que moyen de traitement une lentille 804, qui peut être la lentille 316 des figures 3 et 4, recevant le rayonnement lumineux connecté par le miroir parabolique 802 et l'injectant dans un spectromètre 806 dont l'entrée est symbolisée par le plan 808. Le spectromètre 806 comprend une lentille 810 disposée en amont du réseau 812 du spectromètre 806 et qui renvoie le rayonnement lumineux entrant dans le spectromètre 806 sur le réseau 812 du spectromètre 806. Le spectromètre 806 comprend en outre une lentille 814 disposée en aval du réseau 812 du spectromètre 806 qui symbolise la sortie du spectromètre et qui renvoie le rayonnement lumineux sortant du spectromètre 806 vers une caméra CCD 816. Le spectromètre 806 et la caméra 816 constituent les moyens d'analyse du système de cathodoluminescence.

Selon cet aspect de l'invention, le miroir parabolique, la lentille 804, le spectromètre 806 sont choisis et positionnés tels que :

- le miroir parabolique 802 présente une valeur p de 2 mm et une épaisseur de 3 mm;
- l'angle maximal de sortie du miroir parabolique 802 est de zéro (faisceau parallèle) et l'angle maximal d'entrée de la lentille 804 est de zéro (faisceau parallèle) ;
- le profil du rayonnement provenant du miroir parabolique 802 dans le plan d'entrée de la lentille 804 est de 9 mm sur 3 mm et le diamètre utile en entrée de la lentille 802 est de 8 mm ;

- en considérant le centre du miroir parabolique comme étant le point milieu entre ses surfaces horizontales et verticales (parallèles à l'axe optique de la lentille), le décalage de la lentille 804 par rapport au centre du miroir parabolique est inférieur à 100 microns. La position du foyer du miroir est dans ces conditions calculée pour obtenir le maximum d'angle de collection pour le miroir ; et
- l'angle maximal de sortie de la lentille 804 est de 6.3.

Par ailleurs :

- la largeur du faisceau à l'entrée dudit spectromètre dans la direction dispersive est de typiquement 100 ou 70 microns et le diamètre limite à l'entrée du spectromètre en dessous duquel la résolution du spectromètre ne dépend plus du diamètre de la taille du rayonnement lumineux à l'entrée du spectromètre est de 70 $\mu$m.

En outre :

- la précision du déplacement dans au moins une des deux directions de l'espace perpendiculaire à l'axe optique et dans la direction de l'axe optique est meilleure que ou égale à 1$\mu$m assurant une résolution à l'entrée du spectromètre meilleure que 30 microns, c'est-à-dire inférieure à la taille limite à l'entrée du spectromètre en dessous de laquelle la résolution est dégradée.

La figure 9 est une représentation schématique d'un deuxième exemple du chemin optique d'un système de cathodoluminescence selon le troisième aspect.

Le chemin optique 900 de la figure 9 comprend tous les éléments du chemin optique 800 représenté en figure 8.

Le chemin optique 900 comprend en outre une fibre optique 902, qui peut être la fibre optique 116 des figures 3 et 4. L'entrée de la fibre optique 902 est positionnée au point focal de la lentille 804 et la sortie de la fibre optique est positionnée dans le plan d'entrée du spectromètre 806 matérialisée par le plan 808.

Les paramètres des éléments optiques dans le chemin optique 900 restent identiques aux paramètres donnés en référence à la figure 1.

Cependant :

- la largeur du rayonnement à l'entrée de la fibre optique 902 est, dans le cas ou l'objet étudié est infiniment petit, de l'ordre de 15 microns et le diamètre utile en entrée de la fibre optique est de 70$\mu$m ;
- l'angle maximal du rayonnement provenant de la lentille 804 est de 6.3° et l'angle limite d'incidence en entrée de la fibre optique 902 est de 6.9° ; et
- le décalage de la fibre 902 par rapport au centre de la lentille est inférieur à 100 microns.

Par ailleurs,

- la largeur du faisceau à l'entrée dudit spectromètre dans la direction dispersive est de 70μm et le diamètre limite à l'entrée du spectromètre en dessous duquel la résolution du spectromètre ne dépend plus du diamètre de la taille du rayonnement lumineux à l'entrée du spectromètre est de 70μm.

En outre :

- la précision du déplacement dans au moins une des deux directions de l'espace perpendiculaire à l'axe optique et dans la direction de l'axe optique est meilleure que 1μm assurant une résolution à l'entrée de la fibre optique meilleure que 30 microns, c'est-à-dire inférieure à la taille limite à l'entrée du spectromètre en dessous de laquelle la résolution est dégradée ; et
- le diamètre de chaque fibre optique divisé par le grandissement réalisé sur le chemin optique jusqu'au faisceau de fibre optiques 1002 est de 2 μm.

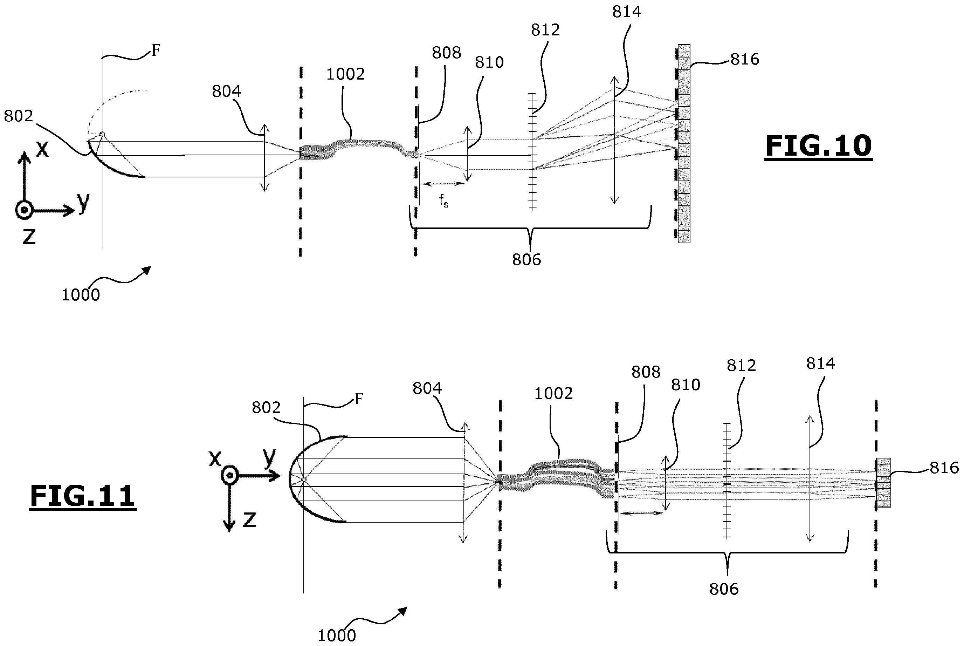

Les Figures 10 et 11 sont des représentations schématiques selon différentes vues d'un troisième exemple du chemin optique d'un système de cathodoluminescence selon le troisième aspect comprenant un faisceau de fibres optiques.
Le chemin optique 1000 des figures 10 et 11 comprend tous les éléments du chemin optique 800 représenté en figure 8.
Le chemin optique 1000 comprend en outre un faisceau de fibres optiques 1002, composées par exemple de plusieurs fibres optiques telles que la fibre optique 902 de la figure 9. L'entrée du faisceau de fibres optiques 1002 est positionnée au point focal de la lentille 804 et la sortie du faisceau de fibres optiques est positionnée dans le plan d'entrée du spectromètre 806 matérialisée par le plan 808.
Les paramètres des éléments optiques dans le chemin optique 1000 restent identiques aux paramètres donnés en référence à la figure 1.
Cependant:

- la largeur du rayonnement à l'entrée du faisceau de fibres optiques 1002 est supérieure ou égale à 200 microns et le diamètre utile en entrée de chaque fibre optique composant le faisceau de fibres optiques 1002 est de 70 μm ;
- l'angle d'entrée maximum du rayonnement provenant de la lentille 804 est de 6.3 et l'angle limite d'incidence en entrée dans chaque fibre optique composant le faisceau de fibre optique 1002 est de 6.9°; et
- le décalage du faisceau de fibres optiques 1002 par rapport au centre de la lentille est de de l'ordre de la centaine de microns.

Par ailleurs,

- la largeur du faisceau à l'entrée dudit spectromètre dans la direction dispersive est de 70 μm, et le diamètre limite à l'entrée du spectromètre en dessous duquel la résolution du spectromètre ne dépend plus du diamètre de la taille du rayonnement lumineux à l'entrée du spectromètre est de 70 μm.

En outre :

- la précision du déplacement dans au moins une des deux directions de l'espace perpendiculaire à l'axe optique et dans la direction de l'axe optique est de 1 μm ou meilleure que 1 μm assurant une résolution à l'entrée de la fibre optique meilleure que 30 microns, c'est-à-dire inférieure à la taille limite à l'entrée du spectromètre en dessous de laquelle la résolution est dégradée ; et
- le diamètre de chaque fibre optique divisé par le grandissement réalisé sur le chemin optique jusqu'au faisceau de fibre optiques 1002 est de 2 μm.

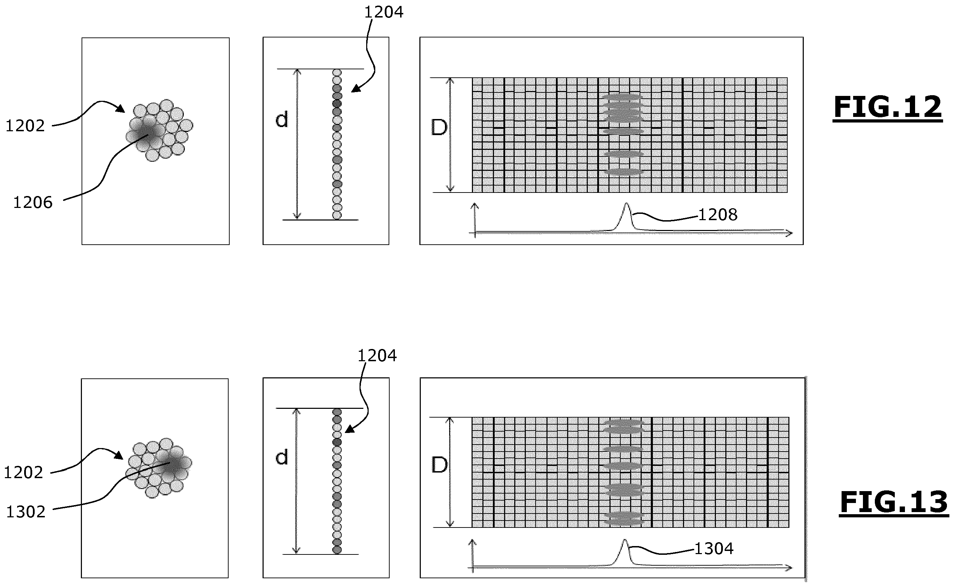

Chacun de ces trois exemples de réalisation permet de véhiculer le rayonnement lumineux émis par l'échantillon jusqu'à la caméra CCD tout en conservant plus d'intensité de lumineux, une résolution spectrale optimale et la possibilité d'utiliser l'invention dans un microscope à particules chargées capables de former des sondes de tailles nanométriques voire angstromiques.
Par ailleurs, le troisième exemple représenté sur les figures 10 et 11 permet également de corriger les erreurs dynamiques, systématiques ou des erreurs dues à un balayage de l'échantillon.
Pour cela, à l'entrée 1202 du faisceau 1002, les fibres optiques composant le faisceau 1002 sont disposées de manière circulaire ou hexagonale, les unes autour des autres. A la sortie 1204 du faisceau 1002, les fibres optiques composant le faisceau 1002 sont alignées, les unes sur les autres, dans une direction perpendiculaire à la direction de dispersion du spectromètre. L'entrée 1202 et la sortie 1204 du faisceau de fibre optiques 1002 sont représentées de manière schématique sur les figures 12 et 13.
Les figures 12 et 13 qui sont des représentations schématiques de deux configurations dans lesquelles le rayonnement lumineux arrive à l'entrée du faisceau de fibres optiques en deux positions différentes dans le système des figures 10 et 11. Dans la configuration représentée en figure 12, le rayonnement lumineux atteint l'entrée 1202 du faisceau 1002 de fibres optiques en un point 1206 décalé vers la gauche par rapport à son centre et dans la configuration représentée en figure 13, le rayonnement lumineux atteint l'entrée 1202 du faisceau 1002 de fibres optiques en un point 1302 décalé vers la droite par rapport à son centre. En fonction des fibres concernées, le rayonnement lumineux entrant dans le faisceau 1002 de fibres optiques ne sort pas du faisceau 1002 de fibres optiques aux mêmes positions. Cependant, dans les deux cas et malgré la différence de position du rayonnement lumineux arrivant dans le plan d'entrée du faisceau 1002 de fibres optiques, l'ensemble du rayonnement est capté et véhiculé jusqu'au spectromètre par le faisceau 1002 de fibres optiques et les spectres 1208 et 1304 obtenus au niveau de la caméra CCD pour chacun des deux rayonnements sont identiques. Ceci se fait sans perte de résolution spectrale ni d'intensité.

Les trois aspects peuvent être combinés, deux à deux ou les trois sur un unique système de cathodoluminescence.

Bien sûr, l'invention n'est pas limitée aux exemples qui viennent d'être décrits et de nombreux aménagements peuvent être apportés à ces exemples sans sortir du cadre de l'invention.

**Revendications**

1. Système de détection de cathodoluminescence (110) comprenant :

   - une source de particules chargées agencée pour éclairer un échantillon (106) avec un faisceau de particules chargées (104), et
   - un chemin optique (800,900,1000) comprenant au moins deux éléments optiques prévus pour collecter et transporter un rayonnement lumineux (108) provenant dudit échantillon (106) éclairé vers des moyens d'analyse (118,806) ;

   ledit système étant **caractérisé en ce que** chaque élément optique dudit chemin optique est choisi de sorte que :

   - l'angle maximal de sortie dudit élément optique est inférieur ou égal à 120% de l'angle maximal d'acceptance de l'élément optique suivant ; et
   - le diamètre du rayonnement provenant dudit élément optique dans le plan d'entrée de l'élément optique suivant est inférieur ou égal à 120% du diamètre utile d'entrée de l'élément optique suivant.

2. Système selon la revendication 1, **caractérisé en ce que** chaque élément optique du chemin optique est choisi de sorte que l'angle maximal de sortie dudit élément optique est inférieur ou égal à l'angle maximal d'acceptance de l'élément optique suivant.

3. Système selon l'une quelconque des revendications précédentes, **caractérisé en ce que** chaque élément optique du chemin optique est choisi de sorte que le diamètre du rayonnement provenant dudit élément optique dans le plan d'entrée de l'élément optique suivant est inférieur ou égal au diamètre utile d'entrée dudit élément optique suivant.

4. Système selon l'une quelconque des revendications précédentes, **caractérisé en ce que** chaque élément optique du chemin optique est positionné de sorte que le décalage d'un élément optique par rapport au centre de l'élément optique précédent vérifie la relation suivante :

$$Ds_i/2 \leq 1{,}2De_{i+1}/2 - \Delta_{i+1} \quad pour\ i=1...N-1$$

   avec :

   - N le nombre total d'élément optique du chemin optique
   - $\Delta_{i+1}$ le décalage de l'élément optique i+1 par rapport au centre de l'élément optique i,
   - $De_{i+1}$ le diamètre utile d'entrée de l'élément i+1,
   - $Ds_i$ le diamètre du rayonnement provenant de l'élément i mesuré à l'entrée de l'élément i+1.

5. Système selon la revendication précédente, **caractérisé en ce que** chaque élément optique du chemin optique est positionné de sorte que le décalage d'un élément optique par rapport au centre de l'élément optique précédent vérifie la relation suivante :

$$Ds_i/2 \leq De_{i+1}/2 - \Delta_{i+1} \quad pour\ i=1...N-1$$

6. Système selon l'une quelconque des revendications précédentes, **caractérisé en ce qu'**au moins un élément optique du chemin optique est un spectromètre (806), et plus particulièrement un spectromètre comprenant un élément focalisant à son entrée, ledit spectromètre ainsi que les autres éléments optiques dudit chemin optique étant choisis de sorte que la taille du rayonnement à l'entrée du spectromètre suivant la direction dispersive est inférieure ou égale à 10 fois, et préférentiellement à une fois, le diamètre limite à l'entrée dudit spectromètre en dessous duquel la résolution dudit spectromètre ne dépend plus du diamètre dudit rayonnement lumineux à l'entrée dudit spectromètre.

7. Système selon la revendication 6, **caractérisé en ce que** l'élément optique précédent le spectromètre (806) comprend une fibre optique (116,902,1002) dont la sortie est positionnée ou imagée à l'entrée dudit spectromètre, ladite fibre optique et l'élément optique précédent ladite fibre optique étant choisis de sorte que :

   - le diamètre du rayonnement provenant de l'élément optique précédent ladite fibre optique mesuré à l'entrée de ladite fibre optique est inférieur ou égal à 120 %, préférentiellement inférieur ou égal à 100%, du diamètre utile de ladite fibre optique, et
- l'angle d'entrée maximum du rayonnement provenant de l'élément optique précédent ladite fibre optique est inférieur ou égale à 120 %, préférentiellement inférieur ou égal à 100%, de l'angle limite d'incidence de ladite fibre optique.

**8.** Système selon la revendication 6, **caractérisé en ce que** l'élément optique précédant le spectromètre (806) comprend une pluralité de fibres optiques composant un faisceau de fibres optiques (1002) :

- lesdites fibres optiques dudit faisceau étant alignées, du côté dudit spectromètre, perpendiculairement à l'axe de dispersion dans le plan d'entrée dudit spectromètre, et
- la somme des diamètres de l'ensemble desdites fibres optiques est inférieure ou égale à la taille du détecteur du spectromètre suivant la direction non dispersive divisée par le grandissement du spectromètre suivant la direction non dispersive ; et

chaque fibre optique composant ledit faisceau de fibres optiques (1002) est choisie de sorte que :

- le diamètre du rayonnement provenant de l'élément optique précédent à l'entrée de la fibre est inférieur ou égal à 120 %, préférentiellement à 100%, du diamètre utile de ladite fibre optique,
- le diamètre utile de chaque fibre ou de leur image à l'entrée du spectromètre est inférieur ou égal à 120 %, préférentiellement à 100%, du diamètre limite à l'entrée dudit spectromètre en dessous duquel la résolution dudit spectromètre ne dépend plus du diamètre dudit rayonnement lumineux à l'entrée dudit spectromètre
- l'angle d'entrée maximum du rayonnement provenant de l'élément optique précédent à l'entrée de la fibre est inférieur ou égal à 120 %, préférentiellement à 100%, de l'angle limite d'incidence de ladite fibre optique, et
- l'angle de sortie du rayonnement provenant des fibres à l'entrée du spectromètre est inférieur ou égal à 120%, préférentiellement à 100%, de l'angle limite d'entrée dudit spectromètre.

**9.** Système selon l'une quelconque des revendications précédentes, **caractérisé en ce que** l'élément optique précédant le spectromètre comprend une pluralité de fibres optiques composant un faisceau de fibres optiques :

- le faisceau de fibres optiques est compact et préférentiellement hexagonale en entrée, et/ou
- le rapport entre le diamètre total du faisceau de fibres et le diamètre d'une fibre est compris entre 3 et 30.

**10.** Système selon l'une quelconque des revendications précédentes, **caractérisé en ce que** le premier élément optique du chemin optique comprend un élément de collection (802) du rayonnement lumineux présentant une épaisseur totale comprise entre 0.5 et 10 mm, et préférentiellement comprise entre 1 et 8 mm.

**11.** Système selon la revendication 10, **caractérisé en ce que** l'élément de collection (802) du rayonnement lumineux présente :

- s'il s'agit d'un paraboloïde de révolution, un paramètre « p » compris entre 0.5 et 20 mm, plus préférentiellement entre 1 et 7 mm, et encore plus préférentiellement entre 1.5 et 5 mm, encore plus préférentiellement entre 1 et 3 mm, ou encore un paramètre « p » de l'ordre de 2 mm à ±1.5 mm ;
- une focale « f » comprise entre 0.25 et 10 mm, plus préférentiellement entre 0.5 et 3.5 mm, et encore plus préférentiellement entre 0.75 et 2.5 mm.

**12.** Système selon l'une quelconque des revendications précédentes, **caractérisé en ce que** les éléments optiques du chemin optique sont positionnables suivant au moins deux directions de l'espace perpendiculaires à l'axe optique, de sorte que, lorsque le chemin optique comprend un spectromètre, la précision du déplacement d'un élément optique dans au moins une desdites directions est supérieure ou égale :

- à la taille à l'entrée dudit spectromètre, c'est-à-dire la dimension du pixel du détecteur du spectromètre divisé par le grandissement du spectromètre, divisé par le grandissement total réalisé sur le chemin optique entre la source et l'entrée du spectromètre, ou
- lorsque l'élément optique précédent le spectromètre est une fibre ou un faisceau de fibres optiques, au diamètre de la fibre optique, ou de la plus grande des fibres dans le faisceau, divisé par le grandissement total réalisé sur le chemin optique jusqu'à l'entrée de la fibre optique ou du faisceau de fibres optiques.

**13.** Système selon la revendication 12, **caractérisé en ce que** la précision du déplacement d'un élément optique dans au moins une direction est supérieure ou égale :

- à la taille de l'entrée du spectromètre, c'est-à-dire la dimension du pixel du détecteur divisé par le grandissement du spectromètre, divisée par le grandissement réalisé sur le chemin optique entre la source et le plan d'entrée du spectromètre et par l'angle maximal d'acceptance du premier élément optique, ou

- lorsque l'élément optique précédant le spectromètre est une fibre ou un faisceau de fibres optiques, au diamètre de la fibre optique, ou le diamètre de la plus grande fibre dans le faisceau, divisé par le grandissement réalisé sur le chemin optique entre la source et le plan d'entrée de la fibre optique ou du faisceau de fibres et par l'angle maximal d'acceptance du premier élément optique.

14. Microscope (100, 600) comprenant :

- une source (102) d'émission d'un faisceau de particules chargées (104), et
- un système (110) de détection de cathodoluminescence selon l'une quelconque des revendications précédentes.

15. Microscope (100, 600) selon la revendication 14, **caractérisé en ce qu'**il comprend en outre au moins :

- un détecteur fond clair (126),
- un détecteur fond noir (128),
- un détecteur EELS (130),
- une caméra pour l'imagerie ou la diffraction, ou
- un détecteur EDX.

## Patentansprüche

1. System zur Detektion von Kathodolumineszenz (110), umfassend

- eine Quelle von geladenen Teilchen, derart angeordnet, um ein Muster (106) mit einem geladenen Teilchenstrahl (104) zu beleuchten, und
- einen optischen Weg (800, 900) mit mindestens zwei optischen Elementen, die dazu vorgesehen sind, eine vom beleuchteten Muster (106) stammende Lichtstrahlung (108) zu sammeln und zu Analysemitteln (118, 806) hin zu lenken;

wobei das System **dadurch gekennzeichnet ist, dass** jedes optische Element des optischen Wegs derart ausgewählt ist, dass

- der maximale Austrittswinkel aus dem optischen Element kleiner oder gleich 120 % des maximalen Akzeptanzwinkels des nachgelagerten optischen Elements; und
- das Durchmesser der vom optischen Element stammenden Strahlung in der Einfallsebene des nachgelagerten optischen Elements kleiner oder gleich 120 % des Wirkdurchmessers am Eingang des nachgelagerten optischen Elements ist.

2. System nach Anspruch 1, **dadurch gekennzeichnet, dass** jedes optische Element des optischen Wegs derart ausgewählt ist, dass der maximale Austrittswinkel aus dem optischen Element kleiner oder gleich dem maximalen Akzeptanzwinkel des nachgelagerten optischen Elements ist.

3. System nach einem der vorhergehenden Ansprüche, **dadurch gekennzeichnet, dass** jedes optische Element des optischen Wegs derart ausgewählt ist, dass das Durchmesser der vom optischen Element stammenden Strahlung in der Einfallsebene des nachgelagerten optischen Elements kleiner oder gleich dem Wirkdurchmesser am Eingang des nachgelagerten optischen Elements ist.

4. System nach einem der vorhergehenden Ansprüche, **dadurch gekennzeichnet, dass** jedes optische Element des optischen Wegs derart gelagert ist, dass die Verschiebung eines optischen Elements gegenüber dem Mittelpunkt des vorgelagerten optischen Elements folgende Relation hat:

$$Ds_i/2 \leq 1{,}2De_{i+1}/2 - \Delta_{i+1} \quad \text{mit } i=1\ldots N\text{-}1$$

wo:

- N: die Gesamtzahl der optischen Elemente des optischen Wegs,
- $\Delta_{i+1}$: die Verschiebung des optischen Elements i+1 im Vergleich zum Mittelpunkt des optischen Elements i,
- $De_{i+1}$: das Wirkdurchmesser am Eingang des Elements i+1,
- $Ds_i$: das Durchmesser der vom Element i stammenden Strahlung, welche am Eingang des Elements i+1 gemessen wird.

5. System nach dem vorhergehenden Anspruch, **dadurch gekennzeichnet, dass** jedes optische Element des optischen Wegs derart gelagert ist, dass die Verschiebung eines optischen Elements gegenüber dem Mittelpunkt des vorgelagerten optischen Elements folgende Relation hat:

$$Ds_i/2 \leq De_{i+1}/2 - \Delta_{i+1} \quad \text{mit } i=1\ldots N\text{-}1$$

6. System nach einem der vorhergehenden Ansprüche, **dadurch gekennzeichnet, dass** mindestens ein optisches Element des optischen Wegs ein Spektrometer (806) ist, und insbesondere ein Spektrometer mit einem fokussierenden Element an dessen Eingang, wobei das Spektrometer sowie die weiteren optischen Elemente des optischen Wegs derart ausgewählt sind, dass die Größe der Strahlung am Eingang des Spektrometers in der Zerstreuungsrichtung kleiner oder gleich 10 mal oder vorzugsweise einmal das Höchstdurchmesser am Eingang des Spektrometers ist, unter welchem die Auflösung des Spektrometers nicht mehr vom Durchmesser der Lichtstrahlung am Eingang des Spektrometers abhängt.

7. System nach Anspruch 6, **dadurch gekennzeichnet, dass** das optische, dem Spektrometer (806) vorgelagerte Element eine Glasfaser (116, 902, 1002) umfasst, deren Ausgang am Eingang des Spektrometers gelagert bzw. abgebildet wird, wobei die Glasfaser und das optische, der Glasfaser vorgelagerte Element derart ausgewählt sind, dass

- das am Eingang der Glasfaser gemessene Durchmesser der Strahlung, die vom optischen, der Glasfaser vorgelagerten Element stammt, kleiner oder gleich 120 %, vorzugsweise kleiner oder gleich 100 % des Wirkdurchmessers der Glasfaser ist, und
- der maximale Einfallswinkel der Strahlung, die vom optischen, der Glasfaser vorgelagerten Element stammt, kleiner oder gleich 120 %, vorzugsweise kleiner oder gleich 100 % des Höchsteinfallswinkels der Glasfaser ist.

8. System nach Anspruch 6, **dadurch gekennzeichnet, dass** das optische Element, das dem Spektrometer (806) vorgelagert ist, eine Vielzahl von Glasfasern umfasst, welche ein Glasfaserbündel (1002) bilden;

- wobei die Glasfaser des Bündels spektrometerseitig rechtwinklig zur Zerstreuungsachse in der Einfallsebene des Spektrometers ausgerichtet sind, und
- die Summe der Durchmesser aller Glasfaser kleiner oder gleich der Größe des Detektors des Spektrometers in der nicht-dispersiven Richtung ist, geteilt durch die Vergrößerung des Spektrometers in der nicht-dispersiven Richtung; und

jede Glasfaser, woraus das Glasfaserbündel (1002) besteht, derart ausgewählt ist, dass

- das Durchmesser der Strahlung, die vom optischen, der Glasfaser vorgelagerten Element stammt, am Eingang der Glasfaser kleiner oder gleich 120 %, vorzugsweise 100 % des Wirkdurchmessers der Glasfaser ist,
- das Wirkdurchmesser jeder Faser oder derer Abbildung am Eingang des Spektrometers kleiner oder gleich 120 %, vorzugsweise 100 % des Wirkdurchmessers am Eingang des Spektrometers ist, unter welchem die Auflösung des Spektrometers nicht mehr vom Durchmesser der Lichtstrahlung am Eingang des Spektrometers abhängt,
- der maximale Einfallswinkel der Strahlung, die vom vorgelagerten optischen Element stammt, am Eingang der Glasfaser kleiner oder gleich 120 %, vorzugsweise 100 % des Höchsteinfallswinkels der Glasfaser ist, und
- der Austrittswinkel der Strahlung, die von den Glasfasern am Eingang des Spektrometers stammt, kleiner oder gleich 120 %, vorzugsweise 100 % des Höchstwinkels am Eingang des Spektrometers ist.

9. System nach einem der vorhergehenden Ansprüche, **dadurch gekennzeichnet, dass** das optische, dem Spektrometer vorgelagerte Element eine Vielzahl von Glasfasern umfasst, welche ein Glasfaserbündel bilden:

- das Glasfaserbündel ist kompakt und vorzugsweise hexagonal am Eingang, und/ oder
- das Verhältnis zwischen dem Gesamtdurchmesser des Faserbündels und dem Durchmesser einer Faser liegt zwischen 3 und 30.

10. System nach einem der vorhergehenden Ansprüche, **dadurch gekennzeichnet, dass** das erste optische Element des optischen Wegs ein Sammelelement der Lichtstrahlung (802) umfasst, welches eine Gesamtdicke zwischen 0,5 und 10 mm, vorzugsweise zwischen 1 und 8 mm aufweist.

11. System nach Anspruch 10, **dadurch gekennzeichnet, dass** das Sammelelement (802) der Lichtstrahlung wie folgt aufweist:

- wenn es sich um ein Rotationsparaboloid handelt, einen Parameter "p" zwischen 0,5 und 20 mm, eher bevorzugt zwischen 1 und 7 mm, und noch eher bevorzugt zwischen 1,5 und 5 mm, noch eher bevorzugt zwischen 1 und 3 mm, oder einen Parameter "p" der Größenordnung von 2 mm $\pm$1,5 mm;
- eine Brennweite "f" zwischen 0,25 und 10 mm, eher bevorzugt zwischen 0,5 und 3,5 mm und noch eher bevorzugt zwischen 0,75 und 2,5 mm.

12. System nach einem der vorhergehenden Ansprüche, **dadurch gekennzeichnet, dass** die optischen Elemente des optischen Wegs in mindestens zwei Raumrichtungen rechtwinklig zur optischen Achse eingestellt werden können, sodass, wenn der optische Weg einen Spektrometer umfasst, die Genauigkeit der Bewegung eines optischen Elements in mindestens eine dieser Richtungen größer oder gleich ist:

- der Größe am Eingang des Spektrometers, d.h. der Pixelabmessung des Detektors des Spektrometers, geteilt durch die Vergrößerung des Spektrometers, geteilt durch die Gesamtvergrößerung, welche auf dem optischen Weg zwischen der Quelle und dem Eingang des Spektrometers erfolgt, oder
- wenn das dem Spektrometer vorgelagerte optische Element eine Faser oder ein Glasfaserbündel ist, dem Durchmesser der Glasfaser oder der größten Faser im Bündel, geteilt durch die Gesamtvergrößerung, welche auf dem optischen Weg bis zum Eingang der Glasfaser oder des Glasfaserbündels erfolgt.

13. System nach Anspruch 12, **dadurch gekennzeichnet, dass** die Genauigkeit der Bewegung eines optischen Elements in mindestens eine Richtung größer oder gleich ist:

- der Größe des Eingangs des Spektrometers, d.h. der Pixelabmessung des Detektors geteilt durch die Vergrößerung des Spektrometers, geteilt durch die auf dem optischen Weg zwischen der Quelle und der Einfallsebene des Spektrometers erfolgte Vergrößerung und durch den maximalen Akzeptanzwinkel des ersten optischen Elements, oder
- wenn das dem Spektrometer vorgelagerte optische Element eine Faser oder ein Glasfaserbündel ist, dem Durchmesser der Glasfaser oder dem Durchmesser der größten Faser im Bündel, geteilt durch die Vergrößerung, welche auf dem optischen Weg zwischen der Quelle und der Einfallsebene der Glasfaser oder des Faserbündels erfolgt, und durch den maximalen Akzeptanzwinkel des ersten optischen Elements.

14. Mikroskop (100, 600), umfassend:

- eine Emissionsquelle (102) eines Strahls geladener Teilchen (104), und
- eine Vorrichtung (110) zur Detektion von Kathodolumineszenz nach einem der vorhergehenden Ansprüche.

15. Mikroskop (100, 600) nach Anspruch 14, **dadurch gekennzeichnet, dass** es außerdem mindestens umfasst:

- einen Detektor für hellen Hintergrund (126),
- einen Detektor für schwarzen Hintergrund (128),

- einen EELS-Detektor (130),
- eine Kamera für die Abbildung oder die Diffraktion, oder
- einen EDX-Detektor.

**Claims**

1. A cathodoluminescence detection system (110) comprising:

- a source of charged particles arranged to illuminate a sample (106) with a charged particle beam (104), and
- an optical path (800,900,1000) comprising at least two optical components capable of collecting and conveying light radiation (108) coming from said illuminated sample (106) to analysis means (118,806);

said system (110) being **characterised in that** each optical component of said optical path (800,900,1000) is selected so that:

- the maximum output angle of said optical component is less than or equal to 120% of the maximum acceptance angle of the next optical component; and
- the diameter of the radiation coming from said optical component in the input plane of the next optical component is less than or equal to 120% of the useful input diameter of the next optical component

2. The system according to claim 1, **characterized in that** each optical component on the optical path is selected so that the maximum output angle of an optical component is less than or equal to the maximum acceptance angle of the next optical component.

3. The system according to anyone of the preceding claims, **characterized in that** each optical component of the optical path is selected so that the diameter of the radiation coming from an optical component in the input plane of the next optical component is less than or equal to the useful input diameter of the next optical component.

4. The system according to anyone of the preceding claims, **characterized in that** each optical component of the optical path is positioned so that the offset of one optical component relative to the centre of the previous optical component complies with the following relationship:

$$Ds_i/2 \leq 1.2 De_{i+1}/2 - \Delta_{i+1} \quad \text{for } i=1...N-1$$

where:

- N is the total number of the optical components in the optical path
- $\Delta_{i+1}$ is the offset of optical component i+1 relative to the centre of optical component i,
- $De_{i+1}$ is the useful input diameter of component i+1,
- $Ds_i$ is the diameter of the radiation coming from component i measured at the input of component i+1.

5. The system according to the previous claim, **characterized in that** each optical component of the optical path is positioned so that the offset of one optical component relative to the centre of the previous optical component verifies the following equation:

$$Ds_i/2 \leq De_{i+1}/2 - \Delta_{i+1} \quad \text{for } i=1...N-1$$

6. The system according to anyone of the preceding claims, **characterized in that** at least one of the optical components on the optical path is a spectrometer (806), and more particularly a spectrometer comprising a focusing component at its input, said at least one spectrometer and the other optical components of the optical path being selected so that the width of the beam at the input of the spectrometer in the dispersive direction is less than or equal to 10 times, et preferably one time, the limit diameter at the input of the spectrometer below which the resolution of the spectrometer no longer depends on the diameter of the waist of the light radiation at the input of the spectrometer.

7. The system according to claim 6, **characterized in that** the optical component before the spectrometer (806) comprises an optical fibre (116,902,1002) the output of which is positioned or imaged at the input of the spectrometer, said optical fibre and the optical component before the optical fibre can be selected so that:

- the diameter of the beam coming from the previous optical component measured at the input of the fibre is less than or equal to 120%, preferably less than or equal to 100%, of the useful diameter of the optical fibre, and
- the maximum input angle of the beam coming from the previous optical component is less than or equal to 120%, preferably less than or equal to 100%, of the limit angle of incidence of said optical fibre.

8. The system according to claim 6, **characterized in that** the optical component before the spectrometer (806) comprises a plurality of optical fibres constituting an optical fibre bundle (1002):

- the fibres of said bundle (1002) being aligned, on the side of said spectrometer, perpendicular to the dispersion axis in the input plane of said spectrometer (806), and
- the sum of the diameters of all of the fibres is preferably less than or equal to the size of the detector of the spectrometer (806) in the non-dispersive direction divided by the magnification of the spectrometer (806) in the non-dispersive direction; and

each optical fibre constituting the optical fibre bundle (1002) is selected so that:

- the diameter of the beam coming from the previous optical component at the input of the fibre is less than or equal to 120%, preferably 100%, of the useful diameter of the optical fibre, and
- the maximum input angle of the beam coming from the previous optical component at the input of the fibre is less than or equal to 120%, preferably 100%, of the limit angle of incidence of said optical fibre.

9. The system according to anyone of the preceding claims, **characterized in that** the optical component before the spectrometer comprises a plurality of optical fibres constituting an optical fibre bundle:

- the fibre bundle is compact and preferably have a hexagonal input, and/or
- the ratio between the total diameter of the fibre bundle and the diameter of a fibre can be between 3 and 30.

10. The system according to anyone of the preceding claims, **characterized in that** the first optical component of the optical path comprises a collection component (802) to collect the light radiation, having a total thickness of between 0.5 and 10 mm, and preferably between 1 and 8 mm.

11. The system according to claim 10, **characterized in that** the collection component (802) performing the collection of the light radiation has:

- if it is a paraboloid, a parameter "p" of between 0.5 and 20 mm, more preferably between 1 and 7 mm, and even more preferably between 1.5 and 5 mm, still more preferably between 1 and 3 mm, or a parameter "p" of the order of 2 mm ± 1.5 mm; or
- a focal length "f" of between 0.25 and 10 mm, more preferably between 0.5 and 3.5 mm, and still more preferably between 0.75 and 2.5 mm.

12. The system according to anyone of the preceding claims, **characterized in that** the optical components of the optical path are capable of being positioned in two dimensions of space perpendicular to the optical axis, such that, when the optical path comprises a spectrometer, the accuracy of the movement in at least one of the two directions is better than or equal to:

- the size at the spectrometer input, i.e. the dimension of the pixel of the detector divided by the magnification of the spectrometer, divided by the total magnification produced on the optical path between the source and the spectrometer input, or
- when the optical component before the spectrometer is a fibre or an optical fibre bundle, the diameter of the optical fibre, or of the largest fibre in the bundle, divided by the total magnification produced on the optical path up to the input of the optical fibre or optical fibre bundle.

13. The system according to claim 12, **characterized in that** the accuracy of the displacement of an optical component in at least one direction is greater than or equal to:

- the size of the spectrometer input, i.e. the dimension of the pixel of the detector divided by the magnification of the spectrometer, divided by the magnification produced on the optical path between the source and the spectrometer input plane and by the maximum acceptance angle of the first optical component, or
- when the last optical component is a fibre or an optical fibre bundle, the diameter of the optical fibre, or the diameter of the largest fibre in the bundle, divided by the magnification produced on the optical path between the source and the input plane of the optical fibre or fibre bundle and by the maximum acceptance angle of the first optical component.

14. A microscope comprising:

- a source of emission of a charged particle beam, and
- a cathodoluminescence detection system according to the invention.

15. The microscope according to the previous claim, **characterized in that** it also comprises:

- one bright field detector,
- one dark field detector,
- one EELS detector,
- one camera for imaging or diffraction, or
- one EDX detector.

**FIG. 1**

**FIG. 2**

**FIG. 3**

**FIG. 4**

**FIG. 5**

**FIG. 6**

**FIG. 7**

**FIG.8**

**FIG.9**

**FIG.10**

**FIG.11**

# FIG.12

# FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7589322 B
- US 2003053048 A